# EUROPEAN PATENT SPECIFICATION

(11) **EP 0 369 408 B1**
(45) Date of publication and mention of the grant of the patent: **08.06.1994**
(21) Application number: 89121084.1
(22) Date of filing: 14.11.1989
(51) Int. Cl.: H05K 3/02, H05K 3/36, H05K 1/00, B32B 31/20

(54) **Method for the preparation of metal-foiled polyimide-based film**
Verfahren zur Vorbereitung eines Films auf Polyimid-Basis mit Metallfolie
Méthode pour la préparation d'un film à feuille métallique à base de polyimide

(30) Priority: 15.11.1988 JP 288544/88
(43) Date of publication of application: 23.05.1990
(73) Proprietor: SHIN-ETSU CHEMICAL CO., LTD., Chiyoda-ku Tokyo (JP)
(72) Inventor: Eguchi, Yoshitugu, Kashima-gun Ibaraki-ken (JP); Kuroda, Kouiti, Kashima-gun Ibaraki-ken (JP)
(74) Representative: Jaeger, Klaus, Dr.

(56) References cited:
- EP-A- 0 158 027
- FR-A- 2 369 087

## Description

### BACKGROUND OF THE INVENTION

The present invention relates to an improved method for the preparation of a metal-foiled polyimide-based film or, more particularly, the invention relates to an improved method for the preparation of a metal-foiled polyimide-based film useful as a material of flexible printed circuit boards.

As is well known, the demand for printed circuit boards is rapidly growing in the industry of electronics in recent years along with the trend toward a more and more compact, light-weight and thin design of various electronic devices and components with high performance. Accordingly, the major current of printed circuit boards is under continuous shift from conventional rigid ones to flexible ones which find wider and wider application fields consuming printed circuit boards in large quantities. In view of the increasing opportunity that a very large and complicated electronic circuits with extreme fineness are formed on a single flexible circuit board, it is essentially important that the substrate of a flexible printed circuit board has high dimensional stability.

Conventional base materials of flexible printed circuit boards are prepared by laminating a metal foil such as a copper foil on a flexible film of a synthetic resin such as polyimide. Though advantageous in respect of the relatively high heat resistance, polyimide films have a problem that they have relatively high moisture absorptivity and are dilatable by the absorption of atmospheric moisture under a high-humidity condition and shrinkable when they are brought under a low-humidity condition. In addition, the process of lamination of a polyimide film and a metal foil is conducted usually by applying a considerable tension to the running resin film to cause a tensile elongation thereof under contacting with a hot roller for lamination using an adhesive. Such a tensile elongation is naturally subject to subsequent relaxation to badly affect the dimensional stability of the printed circuit pattern formed thereon to cause serious drawbacks in a finely patterned or large-sized complicated printed circuit board prepared by using such a substrate.

Even worse, the above mentioned dimensional instability of polyimide films varies from lot to lot of the production so that even the most careful process control in the laminating process cannot dissolve the troubles in the flexible printed circuit boards prepared from the copper-foiled polyimide film. This problem is a major factor which influences the yield of acceptable products of flexible printed circuit boards despite the design thereof by taking into account the subsequent shrinkage of the substrate polyimide films.

### SUMMARY OF THE INVENTION

The present invention accordingly has an object to provide a method for the preparation of a metal-foiled polyimide-based film useful as a substrate of flexible printed circuit boards without the above described problems and troubles caused by the dimensional instability of the polyimide films.

Thus, the present invention provides a method for the preparation of a metal-foiled polyimide-based resin film by adhesively bonding a metal foil to at least one surface of the polyimide-based resin film with an interposed layer of a thermosetting adhesive in a continuous laminating process by passing the polyimide-based resin film and the metal foil between a pair of hot laminating rollers, which comprises the steps of:
(a) pretreating a polyimide-based resin film by exposure to a low-temperature plasma of an inorganic gas or by a heat treatment at a temperature in the range from 80 to 200 °C to such an extent that the linear thermal shrinkage of the thus treated film does not exceed 0.05% in each of the longitudinal and transverse directions by heating at 150 °C for 30 minutes;
(b) controlling the tension on the resin film passing between the laminating rollers not to exceed 300 g/mm²;and
(c) keeping the surface temperature of at least one of the laminating rollers, to which the running resin film is contacted, in the range from 60 to 120 °C.

### DETAILED DESCRIPTION OF THE PREFERRED EMBODIMENTS

As is described above, the improvement provided by the present invention comprises (a) the pretreatment of the polyimide-based resin film, prior to lamination, to a specified extent, (b) control of the tension on the resin film in the laminating process not to exceed a specified upper limit, and (c) control of the surface temperature of the laminating rollers, to which the running resin film is contacted, in a specified range. When a copper-foiled resin film prepared by the laminating process with the above mentioned improvement is used as a substrate of a flexible printed circuit board, the substrate suffers little from shrinkage in the manufacturing process involving photolithographic patterning of a resist layer, etching treatment and contacting with a molten solder alloy so that flexible printed circuit boards of outstandingly high dimensional stability can be manufactured with a greatly improved productivity.

The polyimide-based resin film used in the preparation of a copper-foiled resin film according to the inventive improvement is not particularly limitative and commercial products of any grade can be used. Commercial products of polyimide resin films usually have a width of 500 to 1016 mm and a thickness of 12.5 to 125 »m and are obtained in a rolled form. Polyimide resins are prepared by the polycondensation reaction and susceptible to moisture absorption so that commercial products of polyimide resin films generally exhibit large shrinkage in dimensions. Such dimensional instability of polyimide resin films differs from roll to roll. For information, polyimide resin films having three different thickness of 12.5 »m, 25.0 »m and 50.0 »m taken from different rolls as purchased were subjected to the measurement of the heat shrinkage by heating at 150 °C for 30 minutes in the longitudinal and transverse directions and the values obtained with 5 sample pieces were averaged to give each 0.108% for the 12.5 »m thick films, each 0.102% for the 25.0 »m thick films and 0.082% in the longitudinal direction and 0.110% in the transverse direction for the 50.0 »m thick films. Therefore, substrate laminates prepared from such commercial products of polyimide resin films as such unavoidably suffer from unduly large thermal shrinkage and variation thereof.

This problem can be solved according to the inventive improvement by minimizing the thermal shrinkage of the polyimide resin films with stabilized and conditioned shrinking behavior. Namely, the polyimide-based resin film is subjected to a pretreatment, prior to lamination with a metal foil, by an exposure of the surface to an atmosphere of low temperature plasma or by a heat treatment at a temperature in the range from 80 to 200 °C for a length of time ranging from 10 minutes, when the temperature is sufficiently high, to 48 hours, when the temperature is low, to such an extent that the resultant resin film exhibits a thermal shrinkage not exceeding 0.05% in each of the longitudinal and transverse directions by a heat treatment at 150 °C for 30 minutes according to the procedure specified in IPCF C211. It is preferable that the plasma treatment and the heat treatment are both undertaken with either one treatment preceding the other.

The procedure for the surface treatment of a resin film by low temperature plasma per se is well known in the art. Namely, the resin film is continuously introduced into and transferred through a plasma-treatment chamber while the atmosphere inside the chamber is kept under a reduced pressure of 0.001 to 10 torr or, preferably, 0.01 to 1 torr with an inorganic gas. Low temperature plasma is generated inside the plasma-treatment chamber by applying a direct-current or alternate-current voltage of about 0.1 to 10 kV between the electrodes, which may be installed either inside or outside of the chamber, to effect glow discharge through the low-pressure atmosphere of the inorganic gas. The length of time for which the surface of the resin is exposed to the low temperature plasma is usually in the range from about 0.1 second to about 100 seconds. Examples of suitable inorganic gases include rare gases such as argon, oxygen, nitrogen, carbon monoxide, air and the like. The heat treatment of the resin film, which is alternative to or to be combined with the above mentioned plasma treatment, is performed at a temperature in the range from 80 to 200 °C by using a hot-air circulation oven, infrared heater and the like. By undertaking one or both of these pretreatment procedures to the above specified extent, the polyimide resin film is dried and freed from internal stress possibly existing in the film.

The polyimide resin film after the above described pretreatment for conditioning is then laminated with a foil of a metal such as copper on at least one surface with an interposed layer of a thermosetting adhesive on a laminating machine. The procedure of machine lamination is well known in the art. Namely, the running resin film coming out of the plasma-treatment chamber or the oven for the heat treatment is continuously coated with an adhesive on one or both of the surfaces by using a suitable coating machine such as a roll coater and the like followed by heating on an in-line drier to evaporate the solvent, when the adhesive contains a solvent, or to be brought into a semi-cured condition. Thereafter, the adhesive-coated resin film is introduced under a tension together with a metal foil in contact with the adhesive-coated surface of the resin film into laminating rollers kept at an elevated temperature to effect curing of the thermosetting adhesive and adhesive bonding of the metal foil and the resin film by pressing between rollers with the adhesive layer interposed therebetween.

It is essential in practicing the above described laminating process according to the invention that, on one hand, the tension applied to the running resin film through the laminating rollers does not exceed 300 g/mm² in order to minimize the tensile elongation of the resin film after conditioning by the above described pretreatment. It is also essential that, on the other hand, the surface temperature of at least one of the laminating rollers, to which the running resin film is contacted, is kept at a relatively low temperature in the range from 60 to 120 °C. This condition of the low laminating temperature is another factor to minimize tensile elongation of the once conditioned resin film in the laminating process so that the metal-foiled resin film as the product is absolutely free from any wrinkles formed by shrinkage of the resin film to have excellent dimensional stability and appearance. When the tension on the resin film under lamination is too large, an undue elongation is caused in the resin film before the film reaches the laminating rollers so that the resultant metal-foiled resin film exhibits a large shrinkage in the process of the preparation of a printed circuit board using the metal-foiled film as the substrate material, especially, when the resin film has a relatively small thickness of, for example, 12.5 »m or 25.0 »m. When the surface temperature of the laminating rollers is too high, the resin film under lamination is subject to an increased thermal shrinkage so that wrinkles may be formed in the metal foil after lamination. When the surface temperature of the laminating rollers is too low, on the other hand, the semi-cured thermosetting adhesive would be imparted only insufficient flowability and adhesiveness so that the adhesive bonding strength cannot be high enough between the metal foil and the resin film to withstand peeling. The thus metal-foiled resin film is then desirably subjected to a heat treatment, for example, in an oven at a temperature of 80 to 200 °C for 1 hour to several tens of hours to effect complete curing of the thermosetting adhesive.

The thermosetting adhesive used for adhesively bonding a metal foil and a polyimide resin film is required to exhibit a high adhesive bonding strength to withstand peeling and high heat resistance to withstand the elevated temperatures encountered in the manufacturing process of flexible printed circuit boards with the metal-foiled resin film as the substrate material, such as the temperature of a bath of molten solder alloys. Examples of suitable thermosetting adhesives include those based on an epoxy resin, NBR-phenol-based resin, phenol-polyvinyl butyral resin, epoxy-NBR resin, epoxy-modified phenolic resin, epoxy-modified nylon resin, epoxy-modified polyester resin, epoxy-modified or unmodified acrylic resin, polyamide-epoxy-phenolic resin, polyimide resin or silicone resin. The adhesive layer formed on the surface of the resin film should have a thickness, preferably, in the range from 5 to 30 »m.

Various kinds of metal foils can be used for lamination with the polyimide resin film to give a substrate material for flexible printed circuit boards including copper foils, aluminum foil, steel foils, nickel foils and the like, of which rolled or electrolytic copper foils having a thickness of 18 to 70 »m are conventionally used in the preparation of a metal-foiled resin film for flexible printed circuit boards.

In the following, examples are given to illustrate the improvement of the invention in more detail but not to limit the scope of the invention in any way.

### Examples 1 to 5.

In each of the Examples excepting Example 2, a polyimide resin film having a width of 508 mm and a thickness of 12.5 »m (Kapton, a tradename, manufactured by Toray Du Pont Co.) in a roll was subjected to a continuous low temperature plasma treatment. The atmosphere inside the plasma-treatment chamber was kept under a pressure of 0.1 torr by the balance of continuous evacuation and introduction of oxygen gas at a rate of 1.0 liter per minute. Low temperature plasma was generated inside the plasma-treatment chamber by applying a high-frequency electric power of 30 kilowatts at a voltage of 2 kV and a frequency of 110 kHz to a set of four electrodes installed in a diagonal disposition. The resin film was transferred at a velocity of 50 meters per min-ute along a path surrounding the assembly of the electrodes keep-ing a distance of 40 mm from the surface of each electrode.

In the Examples excepting Example 1, the polyimide resin film of 500 meter length in a roll was subjected to a heat treatment either before the plasma treatment (Example 2) or following the plasma treatment (Examples 3 to 5) for 12 hours at a temperature indicated in Table 1 below. The thus plasma- and/or heat-treated resin films were each subjected to the test of thermal shrinkage by heating at 150 °C for 30 minutes in an oven to give the results shown in Table 1, in which the ( - ) (minus) signs are for thermal shrinkage of the films and the ( + ) (plus) signs are for thermal elongation of the films.

The thus plasma- and/or heat-treated resin films were each coated on one surface on a roll coater with an epoxy-modified phenolic adhesive in a coating thickness of 18 »m after evaporation of the solvent by passing through an in-line drier to be brought into a semi-cured condition and then laminated with an electrolytic copper foil having a thicknes of 35 »m applied to the adhesive-coated surface of the resin film in a laminating machine by passing between a pair of laminating rollers to give a line pressure of 20 kg/meter at a line velocity of 3 meters/minute. Table 1 shows the tension in kg on the resin film under lamination and the surface temperature in °C of the lamianting roller to which the running resin film was contacted. The copper-foiled resin film coming out of the laminating machine was wound up in a roll and subjected to a post-treatment by heating in an oven first at 80 °C for 3 hours and then at 160 °C for 5 hours to completely cure the adhesive followed by cooling to room temperature. The copper-foiled resin films were subjected to the evaluation test according to the procedures described below to give the results shown in Table 1.

### Measurement of thermal shrinkage of polyimide resin film

Measurement of the thermal shrinkage of the pretreated polyimide resin film was undertaken according to the procedure specified in IPCF C241 by heating at 150 °C for 30 minutes.

### Measurement of thermal shrinkage of copper-foiled laminate

The resin film after removal of the copper foil by etching was subjected to the measurement of thermal shrinkage by heating at 150 °C for 30 minutes according to the procedure specified in IPCF C241.

### Appearance of copper-foiled resin film

The results of the visual inspection of the appearance were recorded in three ratings of A, B and C relative to the appearance of wrinkles in the copper foil and curling, the rating A corresponding to absolute absence of wrinkles and curling.

### Ashesive bonding strength of copper foil against peeling

Measurement was performed according to the procedure specified in JIS C 6481.

### Heat resistance against molten solder alloy

Measurement was performed according to the procedure specified in JIS C 6481.

### Comparative Examples 1 to 4.

The experimental conditions were about the same as in Examples 1 to 5 excepting omission of both of the plasma treatment and heat treatment for the pretreatment of the resin film or modification of some of the conditions in the pretreatment and/or laminating process as shown in Table 2 below, which also shows the results of the evaluation tests of the products.

### Examples 6 to 11.

The experimental conditions were about the same as in Examples 1 to 5 except that the polyimide resin film had a thickness of 25 »m and the conditions of the pretreatment and/or laminating process were modified as shown in Table 3 below, which also shows the results of the evaluation tests of the products. In Examples 10 and 11, the polyimide resin film was sandwiched with two copper foils to give a double-sided copper-foiled resin film.

### Comparative Examples 5 to 9.

The experimental conditions were about the same as in Examples 6 to 11 excepting omission of both of the plasma treatment and heat treatment for the pretreatment of the resin film or modification of some of the conditions in the pretreatment and/or laminating process as shown in Table 4 below, which also shows the results of the evaluation tests of the products. In Comparative Example 9, the polyimide resin film was sandwiched with two copper foils to give a double-sided copper-foiled resin film.

**Table 1**

| Example No. | 1 | 2 | 3 | 4 | 5 |
|---|---|---|---|---|---|
| Pretreatment | | | | | |
| Plasma treatment | yes | no | yes | yes | yes |
| Temperature, °C, of heat | - | 120 | 120 | 80 | 150 |
| treatment | | | | | |

| Shrinkage of film, % × 10⁻² | | | | | |
|---|---|---|---|---|---|
| Longitudinal direction | -2 | -4 | -1 | -1 | +1 |
| Transverse direction | -1 | -2 | ±0 | ±0 | +3 |

| Lamination | | | | | |
|---|---|---|---|---|---|
| Tension, kg | 0.5 | 1 | 1 | 2 | 3 |
| Temperature of roller, °C | 80 | 100 | 120 | 100 | 100 |

| Copper-foiled laminate | | | | | |
|---|---|---|---|---|---|
| Peeling resistance, kg/cm | 1.8 | 1.7 | 2.0 | 2.0 | 2.1 |
| Solder resistance, °C | 350 | 350 | 350 | 350 | 350 |

| Shrinkage of laminate, % × 10⁻² | | | | | |
|---|---|---|---|---|---|
| Longitudinal direction | -4 | -7 | -3 | -4 | -5 |
| Transverse direction | -2 | -1 | ±0 | ±0 | + 3 |

| Appearance of laminate | | | | | |
|---|---|---|---|---|---|
| Wrinkles | A | A | A | A | A |
| Curling | A | A | A | A | A |

**Table 2**

| Comparative Example No. | 1 | 2 | 3 | 4 |
|---|---|---|---|---|
| Pretreatment | | | | |
| Plasma treatment | no | no | no | yes |
| Temperature, °C, of heat treatment | - | - | 110 | 60 |

| Shrinkage of film, % × 10⁻² | | | | |
|---|---|---|---|---|
| Longitudinal direction | -12 | -12 | -5 | -2 |
| Transverse direction | -13 | -13 | -3 | -1 |

| Lamination | | | | |
|---|---|---|---|---|
| Tension, kg | 1 | 1 | 5 | 5 |
| Temperature of roller, °C | 100 | 150 | 150 | 140 |

| Copper-foiled laminate | | | | |
|---|---|---|---|---|
| Peeling resistance, kg/cm | 1.7 | 1.9 | 1.9 | 2.1 |
| Solder resistance, °C | 350 | 350 | 350 | 350 |

| Shrinkage of laminate, % × 10⁻² | | | | |
|---|---|---|---|---|
| Longitudinal direction | -13 | -16 | -17 | -15 |
| Transverse direction | -12 | -13 | +4 | +3 |

| Appearance of laminate | | | | |
|---|---|---|---|---|
| Wrinkles | A | C | C | C |
| Curling | A | B | C | C |

**Table 3**

| Example No. | 6 | 7 | 8 | 9 | 10 | 11 |
|---|---|---|---|---|---|---|
| Pretreatment | no | yes | yes | yes | yes | yes |
| Temperature, °C, of heat treatment | 180 | 80 | 100 | 150 | - | 120 |

| Shrinkage of film, % × 10⁻² | | | | | | |
|---|---|---|---|---|---|---|
| Longitudinal direction | -4 | -3 | -1 | +1 | -3 | -1 |
| Transverse direction | -4 | -2 | ±0 | +2 | -4 | +1 |

| Lamination | | | | | | |
|---|---|---|---|---|---|---|
| Tension, kg | 1 | 1 | 2 | 3 | 2 | 2 |
| Temperature of roller, °C | 110 | 120 | 90 | 85 | 100 | 110 |

| Copper-foiled laminate | | | | | | |
|---|---|---|---|---|---|---|
| Peeling resistance, kg/cm | 2.4 | 2.4 | 2.1 | 1.9 | 2.0 | 2.3 |
| Solder resistance, °C | 340 | 340 | 340 | 330 | 330 | 330 |

| Shrinkage of laminate, % × 10⁻² | | | | | | |
|---|---|---|---|---|---|---|
| Longitudinal direction | -7 | -6 | -4 | -5 | -7 | -5 |
| Transverse direction | -6 | -5 | -1 | -2 | -5 | -3 |

| Appearance of laminate | | | | | | |
|---|---|---|---|---|---|---|
| Wrinkles | A | A | A | A | A | A |
| Curling | A | A | A | A | A | A |

**Table 4**

| Comparative Example No. | 5 | 6 | 7 | 8 | 9 |
|---|---|---|---|---|---|
| Pretreatment | | | | | |
| Plasma treatment | no | no | no | yes | yes |
| Temperature, °C, | - | 60 | 210 | - | 110 |

| Shrinkage of film, % × 10⁻² | | | | | |
|---|---|---|---|---|---|
| Longitudinal direction | -10 | -8 | -2 | -3 | -1 |
| Transverse direction | -14 | -12 | -1 | -4 | +1 |

| Lamination | | | | | |
|---|---|---|---|---|---|
| Tension, kg | 3 | 5 | 3 | 8 | 8 |
| Temperature of roller, °C | 110 | 50 | 150 | 150 | 170 |

| Copper-foiled laminate | | | | | |
|---|---|---|---|---|---|
| Peeling resistance, kg/cm | 2.1 | 1.3 | 2.4 | 2.4 | 2.6 |
| Solder resistance, °C | 340 | 320 | 340 | 340 | 330 |

| Shrinkage of laminate, % × 10⁻² | | | | | |
|---|---|---|---|---|---|
| Longitudinal direction | -18 | -14 | -17 | -14 | -18 |
| Transverse direction | -12 | -9 | -8 | -10 | -8 |

| Appearance of laminate | | | | | |
|---|---|---|---|---|---|
| Wrinkles | A | A | C | C | C |
| Curling | C | B | C | B | A |

## Claims

1. A method for the preparation of a metal-foiled polyimide-based resin film by adhesively bonding a metal foil to at least one surface of a polyimide-based resin film with an interposed layer of a thermosetting adhesive in a continuous laminating process by passing the polyimide-based resin film and the metal foil between a pair of hot laminating rollers, which comprises the steps of:
(a) pretreating the polyimide-based resin film by an exposure to a low-temperature plasma of an inorganic gas or by a heat treatment at a temperature in the range from 80 to 200 °C to such an extent that the linear thermal shrinkage of the thus treated film does not exceed 0.05% in each of the longitudinal and transverse directions by heating at 150 °C for 30 minutes;
(b) controlling the tension on the resin film passing between the laminating rollers not to exceed 300 g/mm²;and
(c) keeping the surface temperature of at least one of the laminating rollers, to which the running resin film is contacted, in the range from 60 to 120 °C.

2. The method as claimed in claim 1 wherein , in the pretreatment of the polyimide-based resin film in (a), the plasma treatment is followed by the heat treatment.

## Patentansprüche

1. Verfahren zur Vorbereitung eines Harzfilmes auf Polyimidbasis mit einer Metallfolie durch haftendes Verbinden einer Metallfolie mit wenigstens einer Oberfläche eines Harzfilmes auf Polyimidbasis mit einer dazwischen angeordneten Schicht eines aushärtbaren Bindemittels in einem kontinuierlichen Laminatherstellungsprozess durch Hindurchführen des polyimidbasierten Harzfilmes und der Metallfolie zwischen zwei heißen Laminierwalzen, das die Schritte umfaßt des:
(a) Vorbehandeln des polyimidbasierten Harzfilmes durch eine Aussetzung einem Niedrig-Temperatur-Plasma eines anorganischen Gases oder durch eine Wärmebehandlung bei einer Temperatur im Bereich von 80 bis 200°C in derartigem Ausmaß, daß die lineare thermische Schrumpfung des so behandelten Filmes nicht 0,05 % in jede der Längs- und Querrichtung überschreitet, durch Erwärmen bei 150°C für 30 Minuten;
(b) Steuern der Spannung auf den zwischen den Laminierwalzen hindurchtretenden Harzfilm, um nicht 300 g/mm² zu überschreiten; und
(c) Halten der Oberflächentemperatur wenigstens einer der Laminierwalzen, mit denen der Harzfilm in Kontakt gelangt, im Bereich von 60 bis 120°C.

2. Verfahren nach Anspruch 1, wobei bei der Vorbehandlung des polyimidbasierten Harzfilmes in (a) der Plasmabehandlung die Wärmebehandlung folgt.

## Revendications

1. Méthode pour la préparation d'un film de résine à base de polyimide revêtu d'une feuille de métal par liaison adhésive d'une feuille métallique sur une surface au moins du film de résine à base polyimide avec une couche interposée d'un adhésif thermodurcissable selon un procédé de laminage continu en faisant passer le film de résine à base de polyimide et la feuille métallique entre une paire de rouleaux de laminage chauds qui comprend les étapes consistant à :
a) Préchauffer le film de résine à base de polyimide par une exposition à un plasma à faible température d'un gaz inorganique ou par un traitement thermique à une température dans un domaine de 80 à 100° C, d'une manière telle que la contraction thermique linéaire du film ainsi traité ne dépasse pas 0,05 % dans chacune des directions longitudinale et transversale, par chauffage à 150 ° C pendant 30 minutes.
b) Contrôler la tension du film de résine passant entre les rouleaux de laminage de manière qu'elle n'excède pas 300 g/mm², et
c) Maintenir la température de surface d'au moins un des rouleaux de laminage, au contact duquel est situé le film en déplacement, dans un domaine de 60° à 120° C

2. Méthode selon la revendication 1 selon laquelle, lors du pré-traitement du film de résine à base de polyimide dans l'étape (a), le traitement au plasma est suivi du traitement thermique.
